# EUROPEAN PATENT APPLICATION

(11) **EP 4 564 416 A1**
(43) Date of publication of application: **04.06.2025**
(21) Application number: 24216214.7
(22) Date of filing: 28.11.2024
(51) Int. Cl.: H01L 21/78

(54) **CIRCUIT DIE WITH CHAMFERED PASSIVATION LAYER**

(30) Priority: 30.11.2023 US 202318525490
(71) Applicant: NXP USA, Inc., Austin, TX 78735 (US)
(72) Inventor: HILL, Darrell Glenn, 5656AG Eindhoven (NL)
(74) Representative: Hardingham, Christopher Mark

(57) **Abstract**

An integrated circuit die is provided that includes a substrate, a semiconductor device formed on the substrate, and a passivation layer formed over the substrate. The passivation layer has chamfered corners disposed in corner regions of the integrated circuit die. The chamfered corners of the passivation layer are dimensioned to mitigate damage to the passivation layer in the corner regions during die singulation.

## Description

### TECHNICAL FIELD

Embodiments of the subject matter described herein relate generally to integrated circuits, including integrated circuit die having a chamfered passivation layer.

### BACKGROUND

Integrated circuits find application in a wide variety of electronic components and systems. Typically, integrated circuits are formed via wafer fabrication processes in which many integrated circuits are formed on a single wafer of semiconductor material. After formation of such integrated circuits, individual integrated circuit die are separated from the wafer via a die singulation process. Die singulation, sometimes referred to as die separation or wafer dicing, may involve scribing the perimeter of each integrated circuit die, then mechanically breaking the wafer along the scribed lines. Die singulation processes used to cut wafers that are formed from relatively harder substrate materials sometimes result in separation lines meandering slightly at corners of integrated circuit during the mechanical breaking process, which can undesirably reduce yield.

### SUMMARY

A brief summary of various exemplary embodiments is presented below. Some simplifications and omissions may be made in the following summary, which is intended to highlight and introduce some aspects of the various exemplary embodiments, without limiting the scope. Detailed descriptions of an exemplary embodiment adequate to allow those of ordinary skill in the art to make and use these concepts will follow in later sections.

In an example embodiment, an integrated circuit die includes a substrate, a semiconductor device formed on the substrate, and a passivation layer formed over the substrate. The passivation layer has chamfered corners disposed in corner regions of the integrated circuit die. The chamfered corners of the passivation layer are dimensioned to mitigate damage to the passivation layer in the corner regions during die singulation.

In one or more embodiments, in a first corner region of the integrated circuit die, the passivation layer includes a first chamfered surface that extends between a first side surface of the passivation layer and a second side surface of the passivation layer.

In one or more embodiments, a first angle between the first side surface and the first chamfered surface is between 130 and 140 degrees, and a second angle between the second side surface and the first chamfered surface is between 130 and 140 degrees.

In one or more embodiments, the first corner region further includes a first corner of the substrate, a first side surface of the substrate, and a second side surface of the substrate, the first and second side surfaces of the substrate intersect at the first corner of the substrate, a first perpendicular distance between the first corner of the substrate and the first chamfered surface of the passivation layer is greater than a second perpendicular distance between the first corner of the substrate and an intersection between a first plane and a second plane, and the first side surface lies within the first plane and the second side surface lies within the second plane.

In one or more embodiments, the first perpendicular distance is between 1.1 and 10 times greater than the second perpendicular distance.

In one or more embodiments, the semiconductor device includes at least one gallium nitride (GaN) transistor.

In one or more embodiments, the passivation layer includes silicon nitride or silicon oxide.

In one or more embodiments, the substrate includes at least one of GaN or silicon carbide (SiC).

In an example embodiment, an integrated circuit die includes a semiconductor substrate, a semiconductor device formed on the semiconductor substrate, and a passivation layer formed over the semiconductor substrate. The passivation layer includes chamfered corners disposed at respective corner regions of the integrated circuit die. A first corner region of the integrated circuit die includes a first chamfered corner of the chamfered corners and a first corner of the semiconductor substrate, and a first perpendicular distance between a chamfered surface of the first chamfered corner and the first corner of the semiconductor substrate is greater than a second perpendicular distance between the first corner of the semiconductor substrate and an intersection between a first plane and a second plane. The chamfered surface extends between a first side surface of the passivation layer and a second side surface of the passivation layer, the first side surface lies within the first plane, and the second side surface lies within the second plane.

In one or more embodiments, an angle between the chamfered surface and a side surface of the passivation layer that is adjacent to the chamfered surface is between 130 degrees and 140 degrees.

In one or more embodiments, the first perpendicular distance is between 1.1 and 10 times greater than the second perpendicular distance.

In one or more embodiments, the semiconductor device includes at least one gallium nitride (GaN) transistor.

In one or more embodiments, the passivation layer includes silicon nitride or silicon.

In one or more embodiments, the semiconductor substrate includes at least one of GaN or silicon carbide (SiC).

In one or more embodiments, the semiconductor substrate includes a SiC base substrate and at least one epitaxially-grown GaN layer formed over the SiC base substrate.

In an example embodiment, a method of fabricating an integrated circuit die includes providing a substrate, forming a device on the substrate, forming a passivation layer over the substrate, and forming chamfered corners on the passivation layer in corner regions of the integrated circuit die by selectively removing portions of the passivation layer in the corner regions. The chamfered corners are dimensioned to mitigate damage to the passivation layer during die singulation.

In one or more embodiments, forming the passivation layer includes forming dielectric material over the substrate after forming the device.

In one or more embodiments, forming the chamfered corners includes removing corner portions of the passivation layer using a patterned etch process.

In one or more embodiments, the substrate includes a semiconductor substrate, the device includes a semiconductor transistor, and the passivation layer includes oxide or nitride material.

In one or more embodiments, the method includes, after forming the chamfered corners, separating the integrated circuit die from a wafer using a laser-based dicing technique.

### BRIEF DESCRIPTION OF THE DRAWINGS

A more complete understanding of the subject matter may be derived by referring to the detailed description and claims when considered in conjunction with the following figures, wherein like reference numbers refer to similar elements throughout the figures. Elements in the figures are illustrated for simplicity and clarity and have not necessarily been drawn to scale. The figures along with the detailed description are incorporated and form part of the specification and serve to further illustrate examples, embodiments and the like, and explain various principles and advantages, in accordance with the present disclosure, wherein:
FIG. 1 is a block diagram illustrating an example test integrated circuit die having a passivation layer with chamfered corners, in accordance with one or more embodiments;
FIG. 2 is a block diagram illustrating top-down and perspective views of a corner region of an integrated circuit die, such as the integrated circuit die of FIG. 1, which includes a chamfered corner of a passivation layer, in accordance with one or more embodiments;
FIG. 3 is a diagram illustrating a cross-sectional side view of the integrated circuit die of FIG. 1 along the line A-A, in accordance with one or more embodiments; and
FIG. 4 is a process flow chart describing a method of formation and die separation for an integrated circuit die, such as the integrated circuit die of FIG. 1, having chamfered corners, in accordance with one or more embodiments.

### DETAILED DESCRIPTION

The following detailed description is merely illustrative in nature and is not intended to limit the embodiments of the subject matter or the application and uses of such embodiments. Furthermore, there is no intention to be bound by any expressed or implied theory presented in the preceding technical field, background, or the following detailed description.

For simplicity and clarity of illustration, the drawing figures illustrate the general manner of construction, and descriptions and details of well-known features and techniques may be omitted for sake of brevity. Additionally, elements in the drawing figures are not necessarily drawn to scale. For example, the dimensions of some of the elements or regions in the figures may be exaggerated relative to other elements or regions to help improve understanding of embodiments described herein.

The terms "first," "second," "third," "fourth" and the like in the description and the claims, if any, may be used for distinguishing between similar elements and not necessarily for describing a particular sequential or chronological order. It is to be understood that the terms so used are interchangeable under appropriate circumstances such that the embodiments described herein are, for example, capable of operation in sequences other than those illustrated or otherwise described herein. Furthermore, the terms "comprise," "include," "have" and any variations thereof, are intended to cover non-exclusive inclusions, such that a process, method, article, or apparatus that comprises a list of elements is not necessarily limited to those elements but may include other elements not expressly listed or inherent to such process, method, article, or apparatus. The term "coupled," as used herein, is defined as directly or indirectly connected in an electrical or non-electrical manner. As used herein the terms "substantial" and "substantially" mean sufficient to accomplish the stated purpose in a practical manner and that minor imperfections, if any, are not significant for the stated purpose. As used herein, the words "exemplary" and "example" mean "serving as an example, instance, or illustration." Any implementation described herein as exemplary or an example is not necessarily to be construed as preferred or advantageous over other implementations.

Directional references such as "top," "bottom," "left," "right," "above," "below," and so forth, unless otherwise stated, are not intended to require any preferred orientation and are made with reference to the orientation of the corresponding figure or figures for purposes of illustration.

For the sake of brevity, conventional semiconductor fabrication techniques may not be described in detail herein. In addition, certain terms may also be used herein for reference only, and thus are not intended to be limiting. For instance, the terms "first", "second", and other such numerical terms referring to structures do not imply a sequence or order unless clearly indicated by the context.

Various embodiments described herein relate to integrated circuit die with passivation layers having chamfered corners. Conventionally, when performing die singulation to separate integrated circuit die from a wafer, the separation line between adjacent die often meanders slightly at die corners during the mechanical breaking process. This may result in damage to the passivation layer of the integrated circuit die that can potentially compromise moisture integrity of the integrated circuit die and may require that the damaged die be rejected. This issue may be more likely to occur when die singulation is performed on wafers that include relatively hard material (e.g., silicon carbide (SiC), sapphire, etc.) using stealth dicing techniques. Passivation layer damage from separation line meandering during the mechanical breaking process can result in a yield loss of several percent (e.g., up to 5% or more, in accordance with various embodiments).

In one or more embodiments described herein, passivation layer damage in an integrated circuit die may be mitigated by chamfering or beveling corners of the passivation layer prior to die singulation. Herein, the terms "chamfering" and "beveling" are used interchangeably to refer to a process of changing a sharp corner or edge, such as a square (i.e., right angled) corner or edge, to a sloped surface, typically through removal of material at the corner to round or flatten the corner or edge. Herein, a "chamfered corner" or "beveled corner" refers to a corner region of a layer or structure in which a first surface or edge of the layer or structure transitions to a second surface or edge of the layer or structure (e.g., where the first and second surfaces or edges may be perpendicularly aligned) via a sloped surface or edge, which may be formed directly or by chamfering or beveling. Herein a "chamfered surface" or "beveled surface" refers to the sloped surface of a chamfered corner or beveled corner (e.g., the sloped surface extending between two perpendicular edges or surfaces, such as two perpendicular side surfaces of a layer). In various embodiments described herein, chamfered or beveled surfaces and edges of the passivation layer of an integrated circuit die may be flat or substantially flat or may be curved or rounded.

In one or more embodiments, an integrated circuit die may include a passivation layer having chamfered corners, where the chamfered surface of each chamfered corner extends between two side surfaces of the passivation layer. The chamfered corners of the passivation layer may be disposed in respective corner regions of the integrated circuit die. A first perpendicular distance between the chamfered surface of one of the chamfered corners of the passivation layer and a corresponding corner of the integrated circuit die may be greater than (e.g., around 1.1 times greater to around 2.0 times greater than, as non-limiting examples) a second perpendicular distance between an edge or side surface of the passivation layer and an edge or side surface of the integrated circuit die aligned in parallel adjacent to that edge or side surface. Herein, a "perpendicular distance" refers to a distance from one edge, point, or line to another edge point or line measured along a line that is perpendicular to one or both of these. For example, the perpendicular distance between a point and a line is the distance from that point to the nearest point on that line.

In one or more embodiments, the chamfered surface of a chamfered corner of the passivation layer of the integrated circuit may be a substantially flat surface that extends from a first side surface of the passivation layer to a second side surface of the passivation layer, where the chamfered surface intersects the first side surface of the passivation layer at a first angle (e.g., between 130 degrees and 140 degrees, as non-limiting examples) and intersects the second side surface of the passivation layer at a second angle (e.g., between 130 degrees and 140 degrees, as non-limiting examples).

In one or more embodiments, the passivation layer is formed on or over a substrate, and a first perpendicular distance between the chamfered surface and a corresponding corner of the substrate is greater than (e.g., between 1.1 times and 2.0 times greater than, as non-limiting examples) a second perpendicular distance between the corner of the substrate and an intersection point between a first plane in which the first side surface of the passivation layer lies and a second plane in which the second side surface of the passivation layer lies, where the first plane is substantially perpendicular to the second plane. Chamfering or beveling the corners of the passivation layer increases the perpendicular distances between the passivation layer and corners of the substrate, such that meandering of separation lines during the mechanical breakage process of a die singulation process may be less likely to cause damage to the passivation layer. This, in turn, may advantageously reduce yield loss due to passivation layer damage during die singulation.

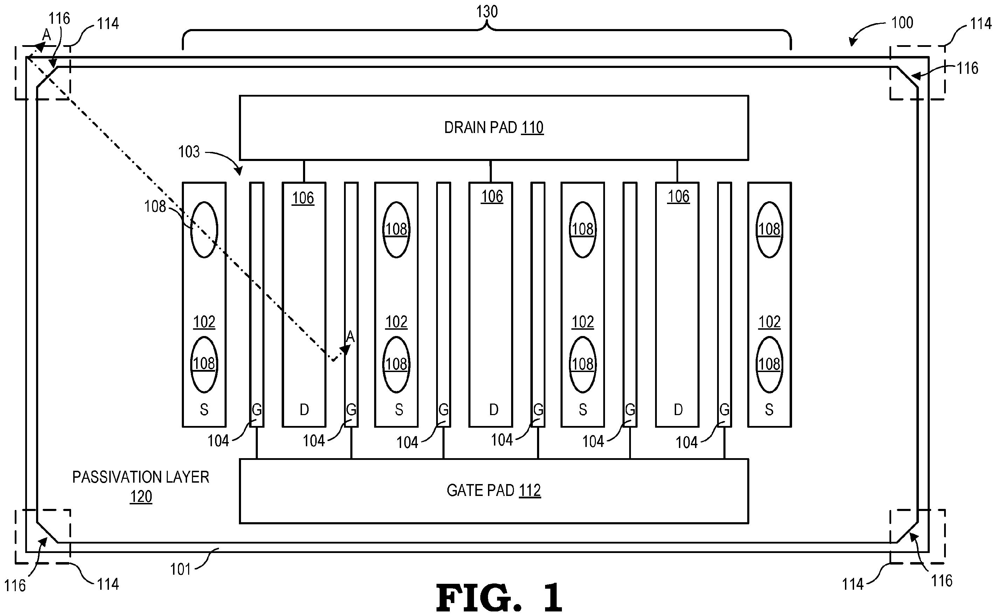

FIG. 1 is an example top view of an example integrated circuit die 100 in accordance with an embodiment. In one or more embodiments, the integrated circuit die 100 includes a substrate 101 that includes silicon carbide (SiC). In one or more other embodiments, the substrate 101 includes one or more layers of material such as sapphire, silicon (Si), gallium nitride (GaN), aluminum nitride (AlN), diamond, boron nitride (BN), poly-SiC, silicon on insulator, gallium arsenide (GaAs), and/or indium phosphide (InP), as non-limiting examples, instead of or in addition to SiC. In one or more embodiments, the substrate 101 includes a SiC base substrate and one or more layers of GaN that is epitaxially grown over the SiC base substrate.

The integrated circuit die 100 may include a passivation layer 120 formed over the substrate 101. The substrate 101 may be rectangular or substantially rectangular in shape, with side surfaces meeting to form sharp corners/edges at around 90 degrees. Corners of the passivation layer 120 may be disposed near corners of the substrate 101 in corner regions 114, and may be chamfered to form chamfered surfaces 116. Side surfaces of the passivation layer may intersect the chamfered surfaces 116 at angles greater than 90 degrees. In one or more embodiments, the passivation layer 120 may include one or more layers of dielectric material. In one or more embodiments, the passivation layer 120 includes an oxide layer, such as a silicon oxide (e.g., SiOz) layer. In one or more embodiments, the passivation layer includes a nitride layer, such as a silicon nitride layer (e.g., SiN). In one or more embodiments, the passivation layer 120 may be formed directly on (i.e., in direct physical contact with) an upper surface of the substrate 101.

The integrated circuit die 100 may include one or more active semiconductor devices, such as transistors, in a device region 130 and/or one or more passive devices (not shown) at a first surface of the integrated circuit die 100. The integrated circuit die 100 may include one regions outside of the device region 130, which may include electrical isolation regions.

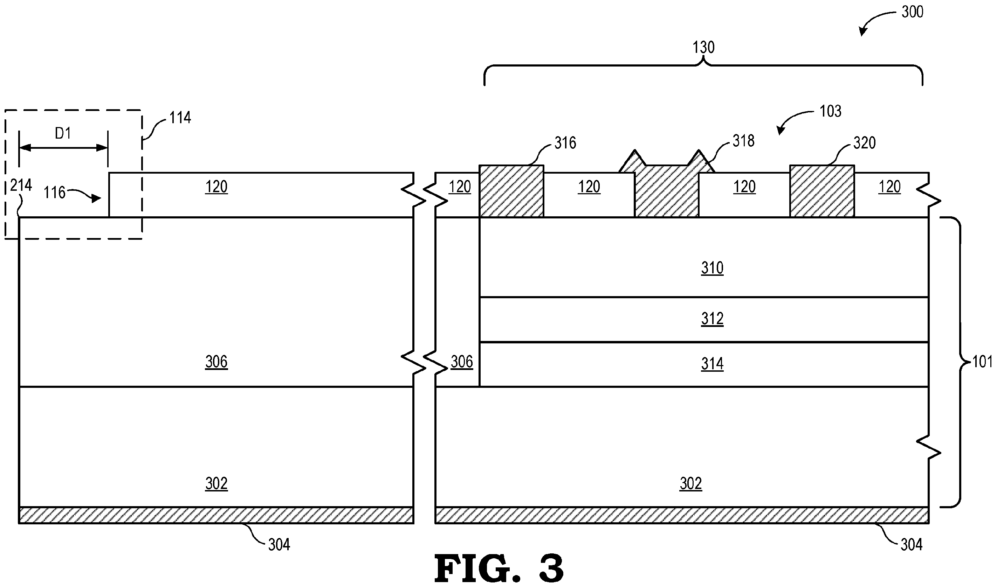

The device region 130 may include a transistor 103. The transistor 103 may be a GaN field effect transistor (FET) defined by multiple structures (sometimes referred to as "fingers") such as a source structure 102 ("S"), a gate structure 104 ("G"), and a drain structure 106 ("D"), where each of the source structure 102, the gate structure 104, and the drain structure 106 are each respectively formed from conductive material (e.g., gold, copper, and/or the like) disposed at the first surface of the integrated circuit die 100. One or more layers of GaN material (sometimes referred to as "GaN layers") of the substrate 101 may be disposed between the base substrate of the substrate 101 and each of the source structures 102, the gate structures 104, and the drain structures 106. For example, such GaN layers may be epitaxially grown on the base substrate of the substrate 101. The drain structure 106 of the transistor 103 may be electrically coupled to a drain pad 110 (e.g., a drain bond pad), and the gate structure 104 of the transistor 103 may be electrically coupled to a gate pad 112 (e.g., a gate bond pad). For example, each of the gate pad 112 and the drain pad 110 includes conductive material disposed at the first surface of the integrated circuit die 100. In one or more embodiments, wire bonds are used to connect the drain pad 110 to the drain structures 106 and to connect the gate pad 112 to the gate structures 104. The source structure 102 of the transistor 103 may be electrically coupled to a layer of electrically conductive material, sometimes referred to herein as a "reference plane" (e.g., the reference plane 304 of FIG. 3), that is disposed at the second surface of the integrated circuit die 100 and that, during operation, is configured to be biased to a reference potential such as a ground voltage. As shown, the device region 130 may include multiple source structures 102, gate structures 104, and drain structures 106, which collectively form multiple transistors. In one or more embodiments, the device region 130 may include other active devices in place of or in addition to the transistors shown in the present example.

In one or more embodiments, the source structures 102 are each coupled to the reference plane by through-substrate vias (TSVs) 108. Each standard TSV 108 corresponds to an opening (e.g., hole) in the substrate 101 that extends between one of the source structures 102 and the reference plane and that includes conductive material that provides an electrical connection between that source structure 102 and the reference plane.

While the device region 130 is shown to include transistors in the present example, this is intended to be illustrative and non-limiting. For example, it should be understood that other active devices and/or passive devices may be included in the device region 130 instead of or in addition to such transistors.

The integrated circuit die 100 may formed via wafer processing and separated from a host wafer via a die singulation process. This die singulation process may include a laser-based dicing process, such as a stealth dicing process that uses laser disruption to damage the wafer along intended scribe lines prior to mechanical breaking to separate integrated circuit die from the wafer. Laser-based dicing processes, such as stealth dicing, which are performed on wafers that include particularly hard materials, such as SiC, may cause separation lines near integrated circuit die corners to meander, which may cause damage to the passivation layer of the integrated circuit die. Such damage to the passivation layer may compromise the moisture integrity that is otherwise provided by the passivation layer, which may result in the integrated circuit die being rejected during testing (e.g., automated optical inspection).

In the present example, by chamfering the corners of the passivation layer 120 to form the chamfered surfaces 116, the distance between the passivation layer 120 and the corners of the substrate 101 is increased in the corner regions 114. This increased distance advantageously reduces the likelihood that the passivation layer 120 will be damaged during the mechanical breakage process of a die singulation process, even in the event that separation lines meander (e.g., curve toward the passivation layer 120, away from the intended scribe lines) at one or more of the corner regions 114. By mitigating damage to the passivation layer 120 in this way, yield loss during manufacture of the integrated circuit die 100 and other similar integrated circuit die may be advantageously reduced (e.g., by as much as 5% or more in accordance with various embodiments).

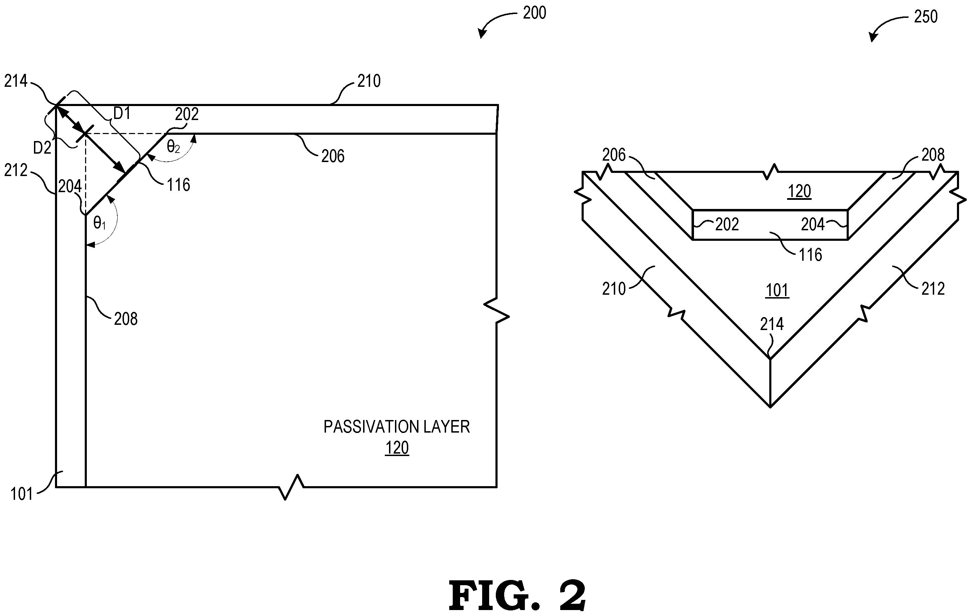

FIG. 2 shows a top-down view 200 and a perspective view 250 of a corner region of an integrated circuit die (e.g., any of the corner regions 114 of the integrated circuit die 100 of FIG. 1, as a non-limiting example) with a chamfered passivation layer. In the example of FIG. 2, like reference numerals are used to denote similar elements in FIG. 1, and some details already discussed above in conjunction with such elements are not necessarily repeated here for sake of brevity.

As shown in the present example, the passivation layer 120 may include side surfaces 206 and 208, where the chamfered surface 116 extends between the side surfaces 206 and 208. The chamfered surface 116 may meet or otherwise intersect the side surface 208 at a first angle θ₁ at an edge 204. The chamfered surface 116 may meet or otherwise intersect the side surface 206 at a second angle θ₂ at an edge 202. In one or more embodiments, each of the angles θ₁ and θ₂ may be between 130 degrees and 140 degrees. In one or more embodiments, the angle θ₁ may be equal to the angle θ₂. In one or more embodiments each of the angles θ₁ and θ₂ may be equal to or approximately (e.g., with a tolerance of +/- 1 degree) equal to 135 degrees.

The perpendicular distance D1 between the chamfered surface 116 and the corresponding corner 214 of the substrate 101 is greater than the perpendicular distance D2 between the corner 214 of the substrate 101 and the location where of the corner of the passivation layer 120 would be had chamfering not been performed (i.e., the location at which a first plane that includes the side surface 208 intersects a second plane that includes the side surface 206). The perpendicular distance D1 is greater than the distance D2 between the corner 214 and the intersection of the planes in which the side surfaces 206 and 208 lie. In one or more embodiments, the perpendicular distance D1 is between 1.1 and 10 times greater than the perpendicular distance D2. In one or more embodiments, the perpendicular distance D1 may be between 1.2 to 5 times greater than the perpendicular distance D2. In one or more embodiments, the perpendicular distance D1 may be between 1.3 to 3 times greater than the perpendicular distance D2. As shown, the chamfering of the corners of the passivation layer 120 also results in the passivation layer being further away from the edges 210 and 212 of the substrate 101 in the corner regions 114. By chamfering corners of the passivation layer 120 in the corner regions 114, damage to the passivation layer 120 caused by scribe line meandering is less likely to occur due, at least in part, to increased distance between the passivation layer 120 and the edges 210 and 212 of the substrate 101 (which also define edges of the integrated die 100) in the corner regions 114.

While the chamfered surface 116 is shown to be substantially flat in the present example, it should be understood that this is intended to be illustrative and non-limiting. In one or more other embodiments, for example, the chamfered surface 116 may instead be curved, defining an arc that extends between the side surfaces 206 and 208.

FIG. 3 is a cross-sectional view 300 of the integrated circuit die 100 of FIG. 1, taken along the line A-A. In the example of FIG. 3, like reference numerals are used to denote similar elements in FIG. 1, and some details already discussed above in conjunction with such elements are not necessarily repeated here for sake of brevity.

As shown, the integrated circuit die 100 may include the substrate 101, which includes a first surface and a second surface. A semiconductor device is formed within the device region 130 proximate to the first surface of the substrate 101. In the present example, the semiconductor device includes one or more transistors, such as the transistor 103, and the substrate 101 includes layers that support transistor operation. For example, the transistor 103 formed in the device region 130 may include a source contact 316 (e.g., the source structure 102 of FIG. 1), a gate 318 (e.g., the gate structure 104 of FIG. 1), a drain contact 320 (e.g., the drain structure 106 of FIG. 1). The gate 318 is formed between the source contact 316 and the drain contact 320. In one or more embodiments, the source contact 316 is electrically connected to the reference plane 304 through one or more standard TSVs (e.g., the standard TSVs 108 of FIG. 1). In one or more embodiments, the gate 318 is electrically connected to a gate pad (e.g., the gate pad 112 of FIG. 1). In one or more embodiments, the drain contact 320 is electrically connected to a drain pad (e.g., the drain pad 110 of FIG. 1). The transistor 103 may be a GaN field effect transistor (FET), as a non-limiting example. The integrated circuit die 100 may include one or more transistors or other devices within the device region 130 formed proximate to the first surface of the substrate 101.

In one or more embodiments, the substrate 101 includes a base substrate 302, a barrier layer 310, a channel layer 312, and a buffer layer 314. In one or more embodiments, the base substrate 302 may include semiconductor material such as Si or SiC as non-limiting examples. In one or more other embodiments, the base substrate 302 may include insulating material, such as sapphire as a non-limiting example.

The buffer layer 314 may be formed over the first surface of base substrate 302. The buffer layer 314 may include one or more group III-nitride (sometimes referred to as "group III-N") semiconductor layers and is supported by the base substrate 302. Each of the semiconductor layers of the buffer layer 314 may include one or more epitaxially grown group III nitride layers, as a non-limiting example. In one or more such embodiments, group-IIInitride epitaxially grown layers of the buffer layer 314 may be N-face or Ga-face material. In one or more other embodiments, the semiconductor layers of the buffer layer 314 may be formed by a suitable process other than epitaxial growth. In one or more other embodiments, the semiconductor layers of the buffer layer 314 may include Si, GaAs, InP, or other suitable materials.

In one or more embodiments, the channel layer 312 is formed over the buffer layer 314. The channel layer 312 may include one or more group III-N semiconductor layers and is supported by the buffer layer 314. For example, the channel layer 312 may include an AlxGai-xN layer where X takes on values between 0 and 1. In an embodiment, the channel layer 312 is configured as GaN (X=0) although other values of X may be used. The thickness of the channel layer 312 may be between about 50 angstroms and about 10,000 angstroms, though other thicknesses may be used.

In one or more embodiments, the barrier layer 310 is formed over the channel layer 312. The barrier layer 310 may include one or more group III-N semiconductor layers and is supported by the channel layer 312. The barrier layer 310 may have a larger bandgap and/or larger spontaneous polarization than the channel layer 312. When the barrier layer 310 is over the channel layer 312, a channel is created in the form of a two-dimensional electron gas (2-DEG) within the channel layer 312 adjacent the interface between the channel layer 312 and the barrier layer 310. In addition, tensile strain between the barrier layer 310 and the channel layer 312 may cause additional piezoelectric charge to be introduced into the 2-DEG and the channel. In one or more embodiments, the barrier layer 310 may include at least one NID AlXGai-xN layer where X takes on values between 0 and 1 or 0.1 to 0.35, although other values of X may be used. The thickness of the NID AlxGai-xN layer of the barrier layer 310 may be between about 50 angstroms and about 1000 angstroms though other thicknesses may be used.

In one or more embodiments, a cap layer (not shown) may be formed over the barrier layer 310. The cap layer presents a stable surface and serves to protect the upper surface of the integrated circuit die 100 from chemical and environmental exposure incidental to wafer processing. The cap layer may include one or more group III-N semiconductor layers and is supported by the barrier layer 310. In an embodiment, the cap layer includes GaN. The thickness of the cap layer may be between about 5 angstroms and about 100 angstroms though other thicknesses may be used.

In one or more embodiments, portions of the passivation layer 120 are formed on the barrier layer 310. In one or more embodiments, portions of the passivation layer 120 provide electrical insulation between the source contact 316 and the gate 318 and between the gate 318 and the drain contact 320.

While the transistor 103 in the above example is described as being a GaN device formed in the device region 130, it should be understood that this is intended to be illustrative and non-limiting. In one or more other embodiments, other suitable active devices or passive devices formed from GaN or other suitable semiconductor material (e.g., silicon, GaAs) and/or insulating material (e.g., silicon oxide, silicon nitride, or other suitable electrically insulating materials) may be formed in the device region 130 instead of or in addition to the transistor 103.

Outside of the device region 130, the substrate 101 includes material 306 may be formed on the base substrate 302. In one or more embodiments, the material 306 is high resistivity material or semi-insulating material, such as ion-bombarded semiconductor material (e.g., ion bombarded GaN, Si, or GaAs as non-limiting examples). In one or more other embodiments, the material 306 is conductive semiconductor material (e.g., electrically conductive GaN or GaAs). In one or more other embodiments, the material 306 includes silicon, metal, dielectric material, or a combination of these. The material 306 may at least partially isolate (e.g., electrically isolate) the device region 130. Portions of the passivation layer 120 may be formed directly on the material 306. As shown, the corner regions 114 of the integrated circuit die 100 may overlap regions of the substrate 101 that include the material 306. The material 306 is exposed when portions of the passivation layer 120 are removed (e.g., when forming the chamfered corners of the passivation layer 120 in the corner regions 114). Chamfering the passivation layer 120 in the corner regions 114 increases the distance D1 between the passivation layer 120 and the corner 214 of the substrate 101, which exposes more of the upper surface of the material 306, and which further reduces the likelihood that the passivation layer 120 will be damaged during die singulation due to scribe line meandering in the corner region 114.

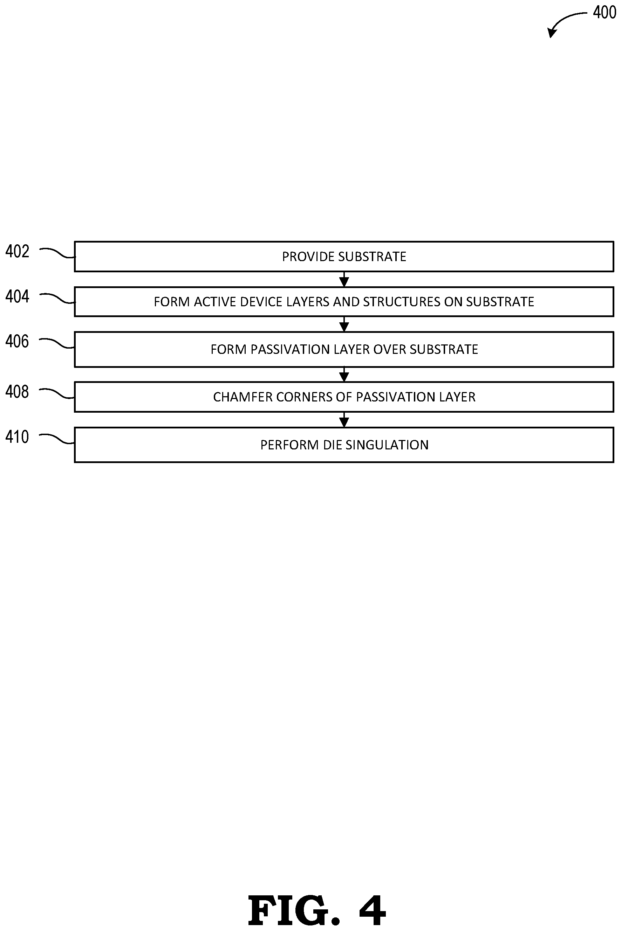

FIG. 4 shows an illustrative process flow for a method 400 by which an integrated circuit die (e.g., the integrated circuit die 100 of FIG. 1) is formed having a passivation layer with chamfered corners, then is separated from a host wafer via die singulation. The method 400 is described with reference to elements of the integrated circuit die 100 as shown in FIG. 1 and in the cross-sectional view 300 of FIG. 3, and descriptions of such elements are not necessarily repeated here for sake of brevity. However, it should be understood that this is illustrative and not limiting, at least in that other suitable integrated circuit die may be fabricated using the method 400, in one or more other embodiments.

At block 402, the substrate 101 is provided. In one or more embodiments, the substrate 101 may include a base substrate (e.g., SiC or sapphire as non-limiting examples) and one or more semiconductor layers (e.g., epitaxially grown GaN layers such as the buffer layer 314, the channel layer 312, and the barrier layer 310, as non-limiting examples) formed over the base substrate.

At block 404 active device layers and structures are formed over and/or in the substrate 101. Such active device layers and structures may include gate, source terminal, and drain terminal structures (e.g., the gates 104 and 318 of FIGS. 1 and 3, the source structures 102 and 316 of FIGS. 1 and 3, and the drain structures 106 and 320 of FIGS. 1 and 3, respectively), as non-limiting examples. TSVs (e.g., the TSVs 108 of FIG. 1) may additionally or alternatively be formed through the substrate 101 at block 404. The active device layers and structures formed at block 404 may be formed using any suitable combination of conventional photolithographic techniques, etching techniques, and material deposition techniques, for example.

At block 406, the passivation layer 120 is formed (e.g., deposited via sputtering, plasma deposition, chemical vapor deposition, evaporation or another suitable deposition process) over the substrate 101. In one or more embodiments, the passivation layer 120 includes one or more layers of dielectric material such as an oxide (e.g., SiOz, as a non-limiting example) or a nitride (e.g., SiN as a non-limiting example).

At block 408, the passivation layer 120 is selectively etched to form chamfered corners at corner regions of the passivation layer. In one or more embodiments, the passivation layer 120 may be etched using a photolithographic process or other suitable patterned etch process to selectively remove portions of the passivation layer 120 at the corner regions 114 of the integrated circuit die 100 to chamfered surfaces 116. In one or more embodiments, formation of the chamfered corners of the passivation layer 120 may be performed concurrently with formation of openings in other regions of the passivation layer 120 (e.g., openings in the device region 130 through which device structures such as gate, source, or drain contacts may be exposed).

At block 410, die singulation is performed to separate the integrated circuit die 100 from its host wafer. In one or more embodiments, the die singulation process may include a laser-based process, such as a stealth dicing process, in which laser energy is applied along intended scribe lines of the host wafer, permeating materials of the host wafer, followed by a mechanical breaking process in which stress is applied to the host wafer to break the wafer along the scribe lines. Forming the passivation layer 120 with chamfered corners at the corner regions 114 of the integrated circuit die 100 may advantageously mitigate or prevent damage to the passivation layer 120 that might otherwise occur during block 410 due to meandering of the separation lines at the corner regions, at least because the chamfering increases the distance between the passivation layer 120 and the corners of the substrate 101 where scribe line meandering is likely to occur. In this way, yield loss of the host wafer may be advantageously reduced due to prevention of passivation layer damage in the integrated circuit die formed therefrom, including the integrated circuit die 100.

The foregoing description refers to elements or nodes or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with) another element, and not necessarily mechanically. Thus, although the schematic shown in the figures depict one exemplary arrangement of elements, additional intervening elements, devices, features, or components may be present in one or more embodiments of the depicted subject matter.

Although the operations of the method(s) herein are shown and described in a particular order, the order of the operations of each method may be altered so that certain operations may be performed in an inverse order or so that certain operations may be performed, at least in part, concurrently with other operations. In another embodiment, instructions or sub-operations of distinct operations may be implemented in an intermittent and/or alternating manner.

It should also be noted that at least some of the operations for the methods described herein may be implemented using software instructions stored on a computer useable storage medium for execution by a computer. As an example, an embodiment of a computer program product includes a computer useable storage medium to store a computer readable program. The computer-useable or computer-readable storage medium can be an electronic, magnetic, optical, electromagnetic, infrared, or semiconductor system (or apparatus or device). Examples of non-transitory computer-useable and computer-readable storage media include a semiconductor or solid-state memory, magnetic tape, a removable computer diskette, a random-access memory (RAM), a read-only memory (ROM), a rigid magnetic disk, and an optical disk. Current examples of optical disks include a compact disk with read only memory (CD-ROM), a compact disk with read/write (CD-R/W), and a digital video disk (DVD).

Alternatively, embodiments described herein may be implemented entirely in hardware or in an implementation containing both hardware and software elements. In embodiments which use software, the software may include but is not limited to firmware, resident software, microcode, etc.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

## Claims

1. An integrated circuit die comprising:
a substrate;
a semiconductor device formed on the substrate; and
a passivation layer formed over the substrate, the passivation layer having chamfered corners disposed in corner regions of the integrated circuit die, wherein the chamfered corners of the passivation layer are dimensioned to mitigate damage to the passivation layer in the corner regions during die singulation.

2. The integrated circuit die of claim 1, wherein, in a first corner region of the integrated circuit die, the passivation layer comprises a first chamfered surface that extends between a first side surface of the passivation layer and a second side surface of the passivation layer.

3. The integrated circuit die of claim 2, wherein a first angle between the first side surface and the first chamfered surface is between 130 and 140 degrees, and a second angle between the second side surface and the first chamfered surface is between 130 and 140 degrees.

4. The integrated circuit die of claim 2 or 3, wherein the first corner region further comprises a first corner of the substrate, a first side surface of the substrate, and a second side surface of the substrate, the first and second side surfaces of the substrate intersect at the first corner of the substrate, a first perpendicular distance between the first corner of the substrate and the first chamfered surface of the passivation layer is greater than a second perpendicular distance between the first corner of the substrate and an intersection between a first plane and a second plane, and the first side surface lies within the first plane and the second side surface lies within the second plane.

5. The integrated circuit die of claim 4, wherein the first perpendicular distance is between 1.1 and 10 times greater than the second perpendicular distance.

6. The integrated circuit die of any preceding claim, wherein the semiconductor device comprises at least one gallium nitride (GaN) transistor.

7. The integrated circuit die of any preceding claim, wherein the passivation layer comprises silicon nitride or silicon oxide.

8. The integrated circuit die of any preceding claim, wherein the substrate comprises at least one of GaN or silicon carbide (SiC).

9. A method of fabricating an integrated circuit die comprising:
providing a substrate;
forming a device on the substrate;
forming a passivation layer over the substrate; and
forming chamfered corners on the passivation layer in corner regions of the integrated circuit die by selectively removing portions of the passivation layer in the corner regions, wherein the chamfered corners are dimensioned to mitigate damage to the passivation layer during die singulation.

10. The method of claim 9, wherein forming the passivation layer comprises:
forming dielectric material over the substrate after forming the device.

11. The method of claim 9 or 10, wherein forming the chamfered corners comprises:
removing corner portions of the passivation layer using a patterned etch process.

12. The method of any of claims 9 to 11, wherein the substrate comprises a semiconductor substrate, the device comprises a semiconductor transistor, and the passivation layer comprises oxide or nitride material.

13. The method of any of claims 9 to 12, further comprising:
after forming the chamfered corners, separating the integrated circuit die from a wafer using a laser-based dicing technique.
